Europäisches Patentamt

(19) European Patent Office

Office européen des brevets

(11) Numéro de publication : **0 210 903 B1**

(12) **FASCICULE DE BREVET EUROPEEN**

(45) Date de publication du fascicule du brevet :
**05.06.91 Bulletin 91/23**

(51) Int. Cl.$^5$ : **H01P 5/08, H03D 9/06**

(21) Numéro de dépôt : **86401491.5**

(22) Date de dépôt : **04.07.86**

(54) **Dispositif de couplage entre un guide d'onde métallique, un guide d'onde diélectrique et un composant semiconducteur, et mélangeur utilisant ce dispositif de couplage.**

Le dossier contient des informations techniques présentées postérieurement au dépôt de la demande et ne figurant pas dans le présent fascicule.

(30) Priorité : **23.07.85 FR 8511246**

(43) Date de publication de la demande :
**04.02.87 Bulletin 87/06**

(45) Mention de la délivrance du brevet :
**05.06.91 Bulletin 91/23**

(84) Etats contractants désignés :
**DE GB NL**

(56) Documents cités :
**US-A- 4 232 401
1979 IEEE MTT-S INTERNATIONAL MICRO-WAVE SYMPOSIUM DIGEST, Orlando, US, 30 avril - 2 mai 1979, pages 208-210, IEEE, New York, US; M.N. AZARMANECHE et al.: "Measurements of dispersion characteristics and field distributions in inverted strip dielec-tric waveguide in millimeter wavelength"
IEEE TRANSACTIONS MICROWAVE THEORY AND TECHNIQUES, vol. MTT-24, no. 11, novembre 1976, pages 821-827, IEEE Microwave Theory and Techniques Society, New York, US; T. ITOH: "Inverted strip dielectric waveguide for millimeter-wave integrated cir-cuits"
IEEE TRANSACTIONS ON MICROWAVE THEORY AND TECHNIQUES, vol. MTT-29, no. 3, mars 1981, pages 263-265, IEEE, New York, US; S. BHOOSHAN et al.: "On the design of transitions between a metal and inverted strip dielectric waveguide for millimeter waves"
IEEE TRANSACTIONS ON MICROWAVE THEORY AND TECHNIQUES, vol. MTT-33, no. 6, juin 1985, pages 539-543, IEEE, New York, US; J.A.G. MALHERBE et al.: "A transition from rectangular to nonradiating dielectric waveguide"**

(56) Documents cités :
**1979 IEEE MTT-S INTERNATIONAL MICRO-WAVE SYMPOSIUM, Orlando, US, 30 avril - 2er mai 1979, pages 211-213, IEEE, New York, US; R. MITTRA et al.: "Multimode waveguide components for millimeter-wave integrated circuits"
IEEE TRANSACTIONS ON MICROWAVE THEORY AND TECHNIQUES, vol. MTT-30, no. 8, août 1982, pages 1241-1247, IEEE Micro-wave Theory and Techniques Society, New York, US; C. YAO et al.: "Monolithic integra-tion of a dielectric millimeter-wave antenna and mixer diode: An embryonic millimeter-wave IC"**

(73) Titulaire : **THOMSON-CSF**
**51, Esplanade du Général de Gaulle**
**F-92800 Puteaux (FR)**

(72) Inventeur : **Letron, Yves**
**THOMSON-CSF SCPI 19, avenue de Messine**
**F-75008 Paris (FR)**

(74) Mandataire : **Taboureau, James et al**
**THOMSON-CSF SCPI**
**F-92045 Paris La Défense Cédex 67 (FR)**

## Description

La présente invention concerne un dispositif de couplage entre un guide d'onde métallique, un guide d'onde diélectrique et un composant actif semiconducteur qui traite le signal hyperfréquence détecté et délivre un signal électrique de sortie sur une ligne microbande.

Ce dispositif de couplage permet de passer d'un signal électrique à très haute fréquence, tel que 94 GHz, véhiculé au moyen de guides d'onde métalliques, à un signal de moindre fréquence, de l'ordre de 1 GHz par exemple, que l'on sait véhiculer et traiter avec des composants électroniques semiconducteurs tels que les transistors et les circuits intégrés. Il permet l'intégration des fonctions électroniques de traitement de signaux. L'invention concerne également un mélangeur simple en structure guide diélectrique à image isolée, utilisant des diodes Schottky à poutres dites "Beam-Lead".

On sait que 94 GHz correspond à une fenêtre dans laquelle les ondes hyperfréquences se transmettent particulièrement bien à travers l'atmosphère terrestre, et cette fréquence est très utilisée pour les transmissions et la détection par radar.

Le passage d'un dispositif tel qu'un guide d'onde métallique à un dispositif tel qu'un circuit électronique sur un substrat, supportant un ou plusieurs composants actifs -diodes, transistors, circuits intégrés-, même au niveau d'une fonction hyperfréquence élémentaire, pose un certain nombre de problèmes. Le développement de fonctions actives en guide diélectrique est plus difficile que celui des fonctions passives. Ceci est principalement dû au fait que le guide diélectrique est une structure ouverte : toute discontinuité introduite par l'implantation d'un composant semiconducteur provoque un rayonnement parasite et, par suite, l'impédance vue par le composant est constituée de trois composantes, une partie résistive due au rayonnement, une partie résistive due à la charge utile et une partie réactive. Par ailleurs l'intégration directe d'un composant semiconducteur dans le guide diélectrique est une approche difficile car elle peut entraîner l'apparition de mode de propagation d'ordre supérieur ou de mode de rayonnement de l'onde hyperfréquence transmise par le guide d'onde métallique.

Les réalisations connues ne constituent pas réellement une intégration de composant dans un guide diélectrique, en ce sens que les diodes sont souvent montées en boitier, ou nécessitent une antenne pour sortir le signal du guide d'onde.

Le dispositif de couplage selon l'invention a les caractéristiques selon le préambule de la revendication 1 connu en soi par le document IEEE TRANSACTIONS MICROWAVE THEORY AND TECHNIQUES, vol. MTT-24, no. 11, novembre 1976, pages 821-827, IEEE Microwave Theory and Techniques Society, New York, US ; T. ITOH : "Inverted strip dielectric waveguide for millimeter-wave integrated circuits", figure 6 et les caractéristiques de la partie caractérisante de la revendication 1.

L'invention sera mieux comprise par la description suivante de quelques exemples de réalisation, celles-ci s'appuyant sur les figures jointes en annexe qui représentent :

– figure 1 : coupe schématique d'un dispositif de couplage entre un guide d'onde métallique et une diode selon l'art connu,

– figure 2 : schéma montrant la transmission des ondes dans un guide d'onde diélectrique couplé à un guide d'onde métallique selon l'invention,

– figure 3 : vue de dessus des métallisations déposées sur le guide d'onde diélectrique montrant la zone de transition et la zone de filtrage, selon l'invention,

– figure 4 : vue en coupe d'un premier type de coupleur selon l'invention,

– figure 5 : vue en coupe d'un second type de coupleur selon l'invention,

– figure 6 : vue de trois quart dans l'espace d'un coupleur selon l'invention.

Afin d'être décrite avec plus de précision, l'invention sera exposée en s'appuyant sur le cas d'un mélangeur hyperfréquence à guide diélectrique à image isolée, ce qui ne restreint pas la portée de l'invention qui s'applique plus généralement à un dispositif de couplage entre un guide d'onde métallique, un guide d'onde diélectrique, et un élément actif semiconducteur.

Dans un mélangeur simple, un signal hyperfréquence transmis par exemple par faisceaux hertziens arrive par le guide d'onde métallique, porté par une fréquence telle que 94 GHz. Pour pouvoir traiter le signal au moyen de circuits électroniques à semiconducteurs, on le mélange avec le signal d'un oscillateur local à $94 \pm 1$ GHz par exemple injecté dans le guide d'onde métallique. Les deux signaux se propagent dans le guide diélectrique sans se mélanger. Ils sont mélangés par la diode, puis filtrés par un filtre passe-bas LC. Il sort du filtre un signal à 1 GHz, que l'on sait traiter au moyen de semiconducteurs.

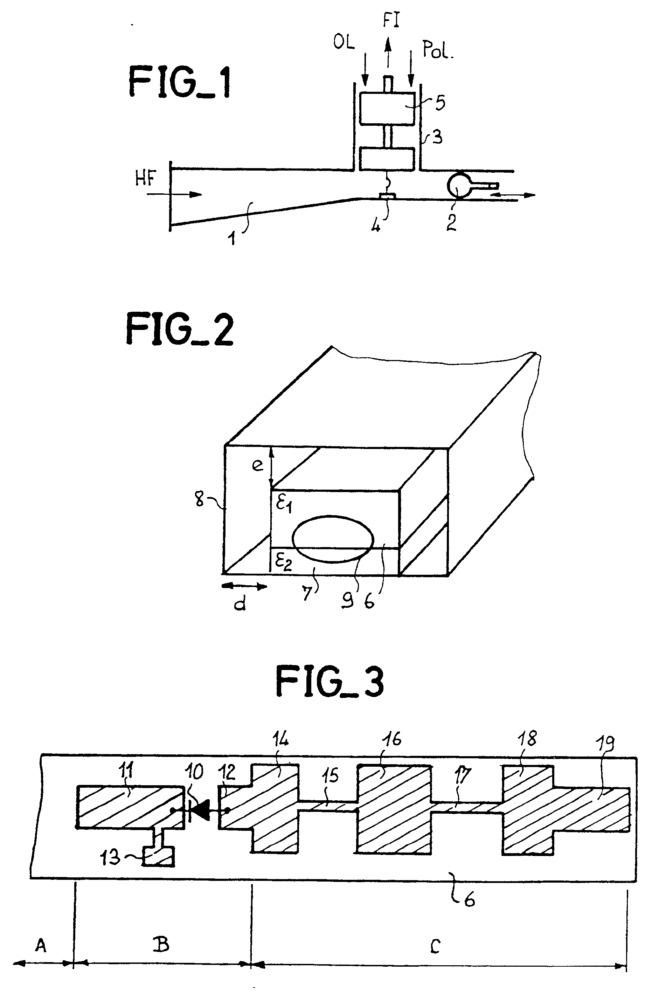

Jusqu'à présent, pour détecter et/ou mélanger un signal HF à 94 GHz, on a utilisé des dispositifs tels que celui qui est schématisé dans la figure 1. Ce mélangeur est constitué par un guide d'onde métallique 1, se terminant à une extrémité par un court circuit mobile 2 et comportant sur un bord une ouverture 3. Une diode 4 est fixée à l'intérieur du guide d'onde métallique à l'aplomb de l'ouverture 3 ; cette diode est polarisée par une tension qui arrive par le filtre de sortie 5 constitué par des capacités et des selfs. Le signal hyperfréquence HF entre dans le guide d'onde 1, ainsi que le signal provenant de l'oscillateur local. Ils sont envoyés sur la diode 4. La diode mélange les deux signaux, et délivre sur la sortie FI un signal intermédiaire. Ce genre de mélangeur, qu'il faut accorder en réglant la position du court-circuit 2, présente l'inconvénient d'être un dispositif à l'intérieur duquel il n'est pas aisé de fixer ou de positionner la diode 4.

Des essais ont été fait pour utiliser des diodes en boitier, et un guide diélectrique comme transition entre le guide d'onde métallique et la diode. Selon d'autres essais on a cherché à utiliser des diodes en boitier intégré dans un guide diélectrique. Dans sa réalisation les diodes Schottky beam-lead sont montées dans une cavité à air à l'extrémité du guide d'onde diélectrique-image, et la surface du guide diélectrique entourant la cavité est métallisée, tandis qu'un capot métallique soudé sur la cavité évite un rayonnement parasite au niveau de la monture de la diode Schottky. Dans d'autres essais, l'oscillateur local est appliqué sur deux diodes Schottky beam-lead en série grâce à une ligne de type microbande, cette ligne microbande traversant le guide d'onde métallique, comme l'antenne de polarisation des dites diodes.

Selon d'autres essais encore, une diode Schottky à pointe est montée dans un trou percé dans le guide diélectrique, et elle est connectée à une structure métallique déposée à la surface du guide diélectrique : il s'agit donc encore d'une structure comportant une cavité dans le guide diélectrique. Enfin une structure à été proposée dans laquelle le composant est monté dans une fente aménagée dans le plan de masse de manière à réduire les pertes à rayonnement. Il ressort de ce qui précède que la plupart des structures étudiées jusqu'à présent sont des structures qui comportent des diodes encapsulées et montées dans les cavités, même si la cavité est selon le dernier exemple cité réalisée dans le plan de masse. Les problèmes soulevés par l'intégration d'un système de couplage entre un guide d'onde métallique et un circuit électronique gravé sur un substrat ont fait ressortir l'importance de trois points cités précédemment, parmi lesquels le premier est la transition entre le guide métallique et le guide diélectrique.

La transition au niveau du guide d'onde métallique se fait selon l'invention au moyen d'un guide diélectrique à image isolée. On appelle guide à image isolée un guide diélectrique monté sur une lamelle dont la permittivité est telle que l'énergie reste dans le guide diélectrique et ne passe pas dans le métal du guide d'onde métallique, puisqu'une partie de l'énergie véhiculée à l'intérieur du guide d'onde diélectrique rayonne à l'extérieur. Ainsi le système de transition, tel qu'il est représenté en figure 2, comporte :

    – un barreau 6 en matériau diélectrique de forte permittivité $\varepsilon_1$, dont une partie au moins est introduite dans le guide d'onde métallique, dont seule la paroi intérieure 8 est représentée sur la figure. Ce barreau en diélectrique 6 est introduit longitudinalement par rapport au guide d'onde, et non pas comme cela s'est fait dans certaines études perpendiculairement ou agissant comme antenne au moyen d'une ligne microbande.

    – Une couche 7 comprise entre le barreau de diélectrique 6 et la paroi du guide d'onde 8. Cette couche 7 a une permittivité $\varepsilon_2$, et elle peut être soit une couche d'air, soit une feuille d'un matériau diélectrique tel que le quartz.

    – Un plan métallique sur lequel est posé l'ensemble du barreau diélectrique 6 et de la couche inférieure 7 : ce plan métallique est une paroi du guide d'onde 8. Le blindage latéral et le couvercle qui entourent le barreau de diélectrique, et qui sont donc constitués par la paroi latérale et supérieure du guide d'onde 8 sont suffisamment éloignés de l'ensemble pour ne pas créer de perturbations. Les calculs et l'expérimentation ont montré que l'éloignement $\underline{e}$ entre la paroi supérieure du guide d'onde et le barreau diélectrique doit être de l'ordre de 0,5 mm, tandis que la distance $\underline{d}$ entre le barreau diélectrique et les parois latérales du guide d'onde métallique 8 sont de l'ordre de 1 mm.

Un guide diélectrique tel que le barreau 6 a une plage d'utilisation comprise entre une fréquence minimum en-dessous de laquelle l'énergie ne se propage plus et une fréquence maximum au delà de laquelle des modes parasites se propagent dans le guide.

Le choix du guide dépend de plusieurs critères :

    – selon sa bande de fonctionnement

    – à l'intérieur de cette bande de fonctionnement, être dans une zone dans laquelle l'essentiel de l'énergie est concentrée dans le guide diélectrique pour éviter l'influence des parois du boitier. Pour ceci, il faut se situer plutôt vers la fréquence maximale d'utilisation qui vient d'être citée.

    – être dans une zone de perte minimale, ce qui nécessite de se placer également vers les fréquences proches de la fréquence maximale d'utilisation.

    – la limite de propagation des modes supérieurs peut correspondre à des modes excités perpendiculairement ou bien à des modes harmoniques. Dans la pratique, les modes perpendiculaires ne sont pas obligatoirement propagés, mais il est préférable de fixer la limite de fonctionnement en deçà de la fréquence maximale.

    – enfin, pour des besoins d'intégration, le barreau de diélectrique doit être suffisamment large pour pouvoir être métallisé sur une face et gravé.

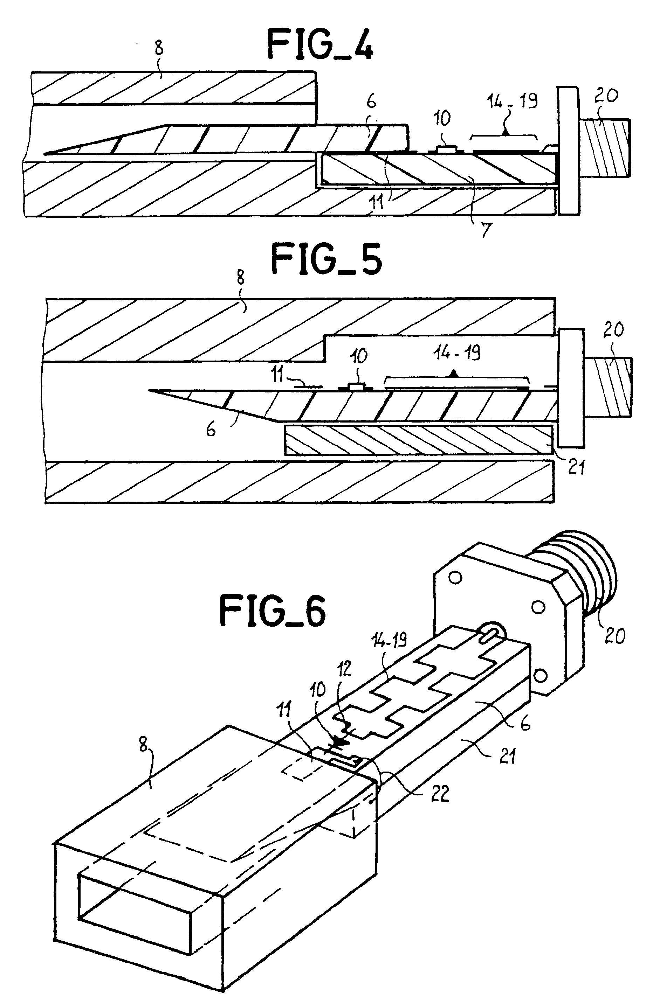

L'ensemble de ces conditions fait choisir un barreau de diélectrique 6 en alumine Al2O3, dont la constante $\varepsilon_1 = 9,8$, dont l'épaisseur est de 0,6 mm et la largeur de 1,2 mm. Pour une bande de fréquence de 90 à 100 GHz, l'adaptation du barreau diélectrique se fait au moyen d'un biseau de 10 mm environ de longueur, qui correspondent au transfert de l'énergie transportée par le guide d'onde métallique 8 vers le guide d'onde diélectrique 6. Une vue du biseau est représentée sur les figures 4, 5 et 6. Il est avantageux que le barreau diélectrique soit le plus court possible. En effet le guide d'onde métallique est un dispositif propre, qui ne fournit pas d'harmonique et ne comporte que peu de perte d'énergie, mais par contre il est difficile d'y introduire une diode. Le guide d'onde diélectrique quant à lui est plus commode que le guide d'onde métallique, et il se prête mieux à l'intégration sur un substrat, mais après un centimètre environ le long d'un barreau diélectrique, l'onde est en partie évanouie et elle comporte des harmoniques. Par conséquent il est préférable d'avoir rapidement un transfert de l'énergie transportée dans le guide d'onde métallique jusqu'à la diode au dispositif semiconducteur qui va détecter et traiter cette forme d'énergie. C'est pourquoi le barreau de diélectrique comporte un biseau de l'ordre de 10 $\lambda g$ de longueur, $\lambda g$ étant la longueur d'onde guidée, la suite du barreau constituant un support pour les métallisations qui y sont déposées, et qui seront détailleés ultérieurement.

La couche 7 de permittivité $\varepsilon_2$ peut être une couche d'air : la variation de l'épaisseur de la lame d'air permet d'intervenir sur la longueur d'onde guidée dans le guide diélectrique. Mais cette couche peut également être une couche d'un matériau diélectrique tel que le quartz. Dans ce cas la longueur d'onde guidée $\lambda_g$ augmente faiblement, mais surtout il est intéressant de savoir qu'une grande partie de l'énergie canalisée par le barreau de diélectrique supérieur 6, c'est-à-dire l'alumine, se propage à l'interface des deux diélectriques. En effet, on a représenté en 9 l'enveloppe approximative de l'énergie transportée dans le guide diélectrique, dont la plus grande partie se trouve certes dans le diélectrique du barreau 6, mais dont une quantité notable, qui constitue ce que l'on appelle l'image, est transportée à l'interface entre les deux diélectriques, et c'est parce que cette image est localisée dans le diélectrique inférieur et isolée par rapport au plan de masse 8 que ce dispositif est appelé à image isolée. Dans ces conditions il est possible de réaliser un mélangeur dans lequel la diode mélangeuse est placée au niveau de l'interface entre les deux diélectriques 6 et 7. Il est alors commode d'utiliser la lame de quartz comme support pour la diode, et de glisser ce quartz, correctement métallisé en surface, sous le barreau diélectrique 6. L'énergie sera transmise depuis l'interface entre les deux diélectrique vers la diode au moyen d'une ligne microbande métallique gravée en surface du quartz, qui constitue donc la structure de couplage entre le guide diélectrique et la diode. Le dessin de cette métallisation est représenté figure 3, qui sera détaillée ci-dessous. Si on utilise une lame de quartz de 300 microns d'épaisseur, l'adaptation est meilleure entre 95 et 96 GHz, par rapport à une lame d'air. En outre une lame de quartz est commode pour soutenir un barreau de diélectrique, tandis qu'une lame d'air nécessite un système de fixation pour le barreau. Le fait qu'il soit possible de recueillir l'énergie à l'interface entre deux diélectriques permet d'adapter la structure de couplage entre guide d'onde métallique et guide d'onde diélectrique par ajustage de la longueur de la zone de couplage entre le guide diélectrique et la microbande sur la plaquette de quartz.

La figure 3 représente une vue de dessus du barreau diélectrique constituant le système de couplage ; elle montre plus particulièrement les métallisations déposées sur l'extrémité de ce guide d'onde diélectrique.

Les différentes zones qui ont été citées, c'est-à-dire la zone de transition guide métallique/guide diélectrique, la zone de couplage entre guide diélectrique et diode, et la zone de filtre à fréquence intermédiaire sont repérées, respectivement, par les lettres A, B et C. La partie du guide diélectrique qui constitue la zone de couplage entre le guide métallique et le guide diélectrique et qui est biseauté est partiellement hors de la figure, pour des raisons d'encombrement, mais est mieux mise en évidence sur les figures 4 et 5.

Le barreau de diélectrique 6 reçoit, dans sa partie terminale qui sert de support et non plus d'adaptation un composant semiconducteur tel qu'une diode 10, montée en beam-lead entre deux microbandes 11 et 12. La microbande 11 constitue l'adaptation entre le guide diélectrique et la diode, et la microbande 12 constitue une longueur d'adaptation de la diode au filtre. Sur le bord de la microbande 11 est prévue une métallisation 13 destinée à amener une polarisation sur la diode. La diode, ou tout autre composant adapté selon l'utilisation recherchée pour ce coupleur entre guide métallique et guide diélectrique, est un composant qui est essentiellement adapté à la fréquence de travail ou à l'utilisation que l'on veut en faire. En particulier elle est montée en surface entre deux métallisations au moyen des poutres beam-lead et ne nécessite ni microboitier d'encapsulation, car elle est protégée par la structure du dispositif, ni un creusement par exemple pour former une cavité dans le barreau de diélectrique.

Le rôle du filtre à fréquence intermédiaire est de séparer les fréquences signal et oscillateur local, voisine de 94 GHz, de la fréquence mélangée qui peut atteindre entre plusieurs centaines de mégahertz jusqu'à plusieurs gigahertz. On peut utiliser soit un filtre passe bande par exemple à 30 GHz soit un filtre passe-bas en constante répartie. Dans le but de réduire les dimensions du filtre, un filtre passe-bas à fréquence de coupure comprise entre 30 et 40 GHz à été choisi. Il est réalisé en structure microbande sur le substrat, qui est soit une lame de quartz si le coupleur comporte un diélectrique et une lame de quartz, soit l'alumine ou l'arseniure de gallium si le coupleur est monolithique. Ce filtre à fréquence intermédiaire est consitué par une suite de métallisations élargies telles que 14, 16 et 18 constituant des capacités, dont le plan de masse, placé sous le barreau diélectrique, constitue l'autre armature. Entre ces zones élargies se placent des microbandes étroites telles 15 et 17, ces métallisations constituant alors des selfs, ce qui fait que le filtre est de type LC.

Ce filtre doit présenter un court-circuit à 94 GHz dans le plan de la diode, ce qui justifie la présence de la bande d'adaptation 12, qui constitue une longueur de ligne ajustable placée à l'entrée du filtre entre le filtre et la diode. Les montages effectués pour le filtre réalisé sur lame de quartz ont été optimisés pour une longueur de cette microbande 12 égale à 3 $\lambda_{eff}/8$. Lorsque le dispositif de couplage est réalisé sur l'alumine, la longueur du ruban gravé étant la même, on ajuste la longueur d'adaptation en modifiant la position du plan de masse.

La figure 4 représente la vue en coupe d'un premier type de coupleur selon l'invention. Dans un guide d'onde 8, et longitudinalement, est introduit le biseau d'un barreau de diélectrique 6 dont l'extrémité non biseautée repose sur une lamelle de quartz 7, l'ensemble constituant les deux matériaux de permittivité $\varepsilon_1$ et $\varepsilon_2$, dont le fonctionnement en guide image isolée a été décrit à l'occasion de la figure 2. La diode 10 est montée par ses poutres sur le quartz 7, la métallisation d'adaptation 12 étant glissée sous le barreau de diélectrique 6. Le quartz sur lequel est gravé le filtre à fréquence intermédiaire, c'est-à-dire les éléments 14 à 19 de la figure 3, est soudé sur le plan de masse du guide métallique 8. L'énergie hyperfréquence est directement couplée entre le guide diélectrique et la ligne microbande. Le court-circuit au niveau de la diode est assuré par le filtre à fréquence intermédiaire. L'élément de réglage essentiel est la longueur de la microbande 12 recouverte par le guide diélectrique 6 qui intervient comme une antenne.

Le signal à fréquence intermédiaire de sortie est prélevé sur la microbande 19 par un connecteur coaxial 20, par lequel arrive également la tension de polarisation de la diode 10.

L'intérêt de ce montage est sa grande souplesse de réalisation et de réglage, car on accède facilement aux divers éléments du circuit, diode, filtre, guide etc... L'inconvénient est sa structure peu intégrée : le mélangeur est constitué de trois éléments de propagation guide métallique, guide diélectrique, filtre à fréquence intermédiaire gravé sur quartz. Par ailleurs l'ensemble du mélangeur n'est pas blindé, une partie de l'énergie rayonne, mais un blindage en même temps qu'un capot de protection peut être apporté, entourant le dispositif à l'extrémité du guide d'onde.

La figure 5 représente la vue en coupe d'un second type de coupleur selon l'invention. Dans ce cas le mélangeur est réalisé en structure semi-intégrée, les métallisations d'adaptation 11 et 12 et le filtre 14 à 19 étant directement gravés sur le guide d'onde diélectrique 6. La diode beam-lead est soudée sur le filtre. Dans ce cas le barreau de diélectrique 6 est supporté par une embase métallique 21 qui sert de plan de masse. Comme dans le cas de figure précédente le signal à fréquence intermédiaire sort au moyen d'un connecteur coaxial 20.

En ce qui concerne le barreau diélectrique 6, la transition entre le guide métallique et le guide diélectrique est assuré par l'intermédiaire d'un biseau de 10 $\lambda g$ de longueur, directement usiné dans le barreau de diélectrique. Celui-ci peut être, en structure semi-intégrée, en alumine ou en tout autre matériau diélectrique convenant bien à ces fréquences. Il peut également être en matériau de type III-V, tel que l'arseniure de gallium par exemple puisqu'on sait d'une part réaliser des barreaux d'arseniure de gallium dans des dimensions suffisantes pour permettre la gravure d'une métallisation, et que d'autre part on sait réaliser de l'arseniure de gallium dit semi-isolant, qui constitue donc un diélectrique. Dans ce cas on peut implanter la diode directement dans le barreau et réaliser ainsi une structure complétement intégrée.

La figure 6 représente une vue de trois quart dans l'espace d'un dispositif de couplage selon l'invention adapté au cas d'un mélangeur. De façon à faciliter la lecture de cette figure, le guide d'onde métallique 8 est supposé être transparent. Le mélangeur comprend donc les éléments suivants qui ont été précédemment décrits :

– une entrée commune du signal à détecter et du signal de l'oscillateur local, par le guide d'onde métallique 8

– une transition entre le guide métallique et le guide diélectrique au moyen d'un biseau usiné dans le diélectrique, de longueur 10 $\lambda_g$, $\lambda_g$ étant la longueur d'onde guidée

– une transition guide diélectrique ligne microruban, la ligne étant gravée sur le même support que le guide : c'est la ligne microbande 11. Un plan de masse est placé directement sous le diélectrique, dans la partie non biseautée.

– la diode mélangeuse, qui est préférentiellement de type beam-lead, soudée sur le microruban entre ses parties 11 et 12. Elle est polarisée par une tension continue qui arrive par l'intermédiaire du connecteur coaxial 20 et est rebouclée à la masse par un fil métallique 22 ;

– un filtre à fréquence intermédiaire, gravé en structure microruban, laisse passer la fréquence intermédiaire et ramène dans le plan de la diode un court-circuit aux fréquences du signal d'entrée et de l'oscillateur local,

– une sortie de signal à fréquence intermédiaire par un connecteur coaxial.

Le dispositif de couplage et le mélangeur selon l'invention sont essentiellement destinés à la détection d'ondes hyperfréquences, en faisceaux hertziens et en radars.

## Revendications

1. Dispositif de couplage entre un guide d'onde métallique, un guide d'onde diélectrique et un composant semiconducteur de traitement d'un signal d'entrée hyperfréquence, le guide d'onde diélectrique (6) de type "image isolée", introduit longitudinalement dans le guide d'onde métallique (8), étant un barreau biseauté de matériau diélectrique, de permittivité $\varepsilon_1$, formant avec un autre matériau diélectrique (7) de permittivité $\varepsilon_2$ un interface au niveau duquel se propage une partie de l'énergie du signal canalisée par le barreau diélectrique (6), ce dispositif étant caractérisé en ce que le biseau s'étend sur une longueur 10 $\lambda$g ($\lambda$g = longueur d'onde guidée), et en ce que l'énergie du signal est couplée au composant semiconducteur (10), fixé sur le guide d'onde diélectrique, au moyen d'une ligne microbande (11) qui constitue une zone de transition entre le guide diélectrique (6) et le composant semiconducteur (10), au niveau de l'interface entre les deux matériaux diélectrique (6, 7), le signal de sortie étant prélevé, par l'intermédiaire d'une seconde microbande (19), par un connecteur coaxial (20).

2. Dispositif de couplage selon la revendication 1, caractérisé en ce que le second matériau diélectrique ($\varepsilon_2$) est une lame de quartz (7), dont la face supportant la ligne microbande (11) est amenée en contact avec le barreau diélectrique (6), par son extrémité non-biseautée, la ligne microbande (11) étant partiellement recouverte par le barreau diélectrique (6) pour recueillir l'énergie à l'interface entre les deux diélectriques (6, 7).

3. Dispositif de couplage selon la revendication 1, caractérisé en ce que le second matériau diélectrique ($\varepsilon_2$) est l'air, le barreau diélectrique (5) comportant, au delà du biseau, un prolongement qui supporte la ligne microbande (11) et le composant semiconducteur (10), ce dispositif de couplage étant monolithique et entièrement supporté par le barreau diélectrique (6).

4. Dispositif de couplage selon la revendication 1, caractérisé en ce que le guide d'onde diélectrique est constitué par un barreau (6) en alumine.

5. Dispositif de couplage selon la revendication 1, caractérisé en ce que le guide d'onde diélectrique est constitué par un barreau (6) en matériau semi-isolant du groupe III-V tel que GaAs.

6. Dispositif de couplage selon la revendication 1, caractérisé en ce que le composant semiconducteur (10) est une pastille nue de diode de type Schottky, montée sur la microbande (11) au moyen de ses poutres de connexions externes (beam-lead).

7. Mélangeur entre un signal d'entrée hyperfréquence et un signal d'oscillateur local, injectés dans le guide d'onde métallique (8), caractérisé en ce qu'il comprend un dispositif de couplage selon la revendication 1 et, en outre, une ligne microbande (12) d'adaptation entre une diode de mélange (10) et un filtre à fréquence intermédiaire, constitué par une pluralité de métallisations larges (14, 16, 18) formant capacités et une pluralité de métallisations étroites (15, 17) formant selfs, l'ensemble des métallisations (11, 12, 14-18) et de la diode (10) étant supporté par un même substrat dont la face arrière est métallisée pour former les capacités et le plan de masse, la sortie en fréquence intermédiaire du mélangeur étant recueillie sur un connecteur coaxial (20) soudé sur une ligne microbande d'adaptation (19), la diode de mélange (10) étant en outre polarisée en continu par l'intermédiaire du connecteur (20).

8. Mélangeur selon la revendication 7, caractérisé en ce que le substrat des métallisations (11, 12, 14-19) et de la diode (10) est une lame de quartz (7) en contact avec le guide diélectrique (6).

9. Mélangeur selon la revendication 7, caractérisé en ce que le substrat des métallisations (11, 12, 14-19) et de la diode (10) est le barreau de diélectrique qui constitue le guide diélectrique (6), ce mélangeur étant intégré et monolithique, le barreau de diélectrique étant un barreau en matériau semi-isolant du groupe III-V tel que GaAs et la diode étant réalisée dans le même matériau.

## Ansprüche

1. Vorrichtung zur Kopplung zwischen einem metallischen Wellenleiter, einem dielektrischen Wellenleiter und einem Halbleiterbauteil zur Behandlung eines Mikrowelleneingangssignals, wobei der dielektrische Wellenleiter (6) vom Typ "isoliertes Bild" in Längsrichtung in den metallischen Wellenleiter (8) eingefügt ist und aus einem abgeschrägten Stab aus dielektrischem Material einer Dielektrizitätskonstante $\varepsilon_1$ besteht, der mit einem anderen dielektrischen Material (7) einer Dielektrizitätskonstante $\varepsilon_2$ eine Grenzschicht bildet, auf deren Niveau ein Teil der Energie des vom dielektrischen Stab (6) kanalisierten Signals sich ausbreitet, dadurch gekennzeichnet, daß die Abschrägung sich über eine Länge von 10 · $\lambda$g erstreckt ($\lambda$g ist die geführte Wellenlänge) und daß die Energie des Signals an das Halbleiterbauteil (10), das auf dem dielektrischen Wellenleiter befestigt ist, über eine Mikrostripleitung (11) angekoppelt ist, die eine Übergangszone zwischen dem dielektrischen Wellenleiter (6) und dem Halbleiterbauteil (10) in Höhe der Grenzschicht zwischen den beiden dielektrischen Materialien (6, 7) bildet, wobei das Ausgangssignal über eine zweite Mikrostripleitung (19) von einem koaxialen Anschluß (20) entnommen wird.

2. Koppelvorrichtung nach Anspruch 1, dadurch gekennzeichnet, daß das zweite dielektrische Material ($\varepsilon_2$) ein Quarzplättchen (7) ist, dessen die Mikrostripleitung (11) tragende Seite mit dem dielektrischen Stab (6), und zwar mit en nicht-abgeschrägtem Ende, in Berührung gebracht wird, wobei die Mikrostripleitung (11) teilweise vom dielektrischen Stab (6) bedeckt wird, um die Energie an der Grenzschicht zwischen den beiden Dielektrika (6, 7) zu empfangen.

3. Koppelvorrichtung nach Anspruch 1, dadurch gekennzeichnet, daß das zweite dielektrische Material ($\varepsilon_2$) Luft ist und daß der dielektrische Stab (6) jenseits der Abschrägung eine Verlängerung aufweist, die die Mikrostripleitung (11) und das Halbleiterbauteil (10) trägt, wobei die Koppelvorrichtung monolithisch ist und vollständig vom dielektrischen Stab (6) getragen wird.

4. Koppelvorrichtung nach Anspruch 1, dadurch gekennzeichnet, daß der dielektrische Wellenleiter von einem Stab (6) aus Aluminiumoxid gebildet wird.

5. Koppelvorrichtung nach Anspruch 1, dadurch gekennzeichnet, daß der dielektrische Wellenleiter von einem Stab (6) aus einem halbisolierenden Material der Gruppe III-V, wie z.B. GaAs gebildet wird.

6. Koppelvorrichtung nach Anspruch 1, dadurch gekennzeichnet, daß das Halbleiterbauteil (10) eine nackte Diodenpastille vom Schottky-Typ ist, die auf der Mikrostripleitung (11) mit Hilfe ihrer Außenanschlußbereiche montiert ist.

7. Mischstufe zwischen einem Mikrowelleneingangssignal und einem lokalen Oszillatorsignal, die in den metallischen Wellenleiter (8) eingespeist werden, dadurch gekennzeichnet, daß sie eine Koppelvorrichtung nach Anspruch 1 sowie außerdem eine Mikrostripleitung (12) zur Anpassung zwischen einer Mischdiode (10) und einem Zwischenfrequenzfilter besitzt, das aus einer Vielzahl von breiten Metallisierungsbereichen (14, 16, 18), die als Kondensatoren wirken, und einer Vielzahl von schmalen Metallisierungsbereichen (15, 17) gebildet wird, die als Induktivitäten wirken, wobei all diese Metallisierungsbereiche (11, 12, 14 bis 18) und die Diode (10) auf demselben Substrat liegen, dessen Rückseite metallbeschichtet ist, um die Kondensatoren und die Masseebene zu bilden, während der Zwischenfrequenzausgang der Mischstufe an einem koaxialen Anschluß (20) liegt, der auf eine Anpassungs-Mikrostripleitung (19) gelötet ist, wobei außerdem die Mischdiode (10) über den koaxialen Anschluß (20) mit einer Gleichspannung vorgespannt wird.

8. Mischstufe nach Anspruch 7, dadurch gekennzeichnet, daß das Substrat, das die Metallisierungen (11, 12, 14 bis 19) und die Diode (10) aus einem Quarzplättchen bestehen, das mit dem dielektrischen Wellenleiter (6) in Kontakt steht.

9. Mischstufe nach Anspruch 7, dadurch gekennzeichnet, daß das Substrat, das die Metallisierungen (11, 12, 14 bis 19) und die Diode (10) trägt, ein Stab aus dielektrischem Material ist, der den dielektrischen Wellenleiter (6) bildet, wobei die Mischstufe ein integrierter und monolithischer Baustein ist und der dielektrische Stab ein Stab aus einem halbisolierenden Material der Gruppe III-V ist, wie z.B. GaAs, wobei die Diode in demselben Material hergestellt ist.

## Claims

1. A coupling device between a metal waveguide, a dielectric waveguide and a semiconductor component intended to process a microwave input signal, the dielectric waveguide (6) of the "isolated image" type being longitudinally inserted into the metal waveguide (8) and being a bevelled rod of a dielectric material whose permittivity is $\varepsilon_1$ and constituting together with another dielectric material (7) of permittivity $\varepsilon_2$ an interface at the level of which a portion of the energy of the signal is propagated which is guided by the dielectric rod (6), characterized in that the bevel extends over a length of $10 \cdot \lambda g$ ($\lambda g$ being the length of the guided wave) and that the signal energy is coupled to the semiconductor component (10) which is fixed to the dielectric waveguide, by means of a microstrip line (11) which constitutes a transition zone between the dielectric guide (6) and the semiconductor component (10) at the level of the interface between the two dielectric materials (6, 7), the output signal being extracted via a second microstrip line (19) by a coaxial connector (20).

2. A coupling device according to claim 1, characterized in that the second dielectric material ($\varepsilon_2$) is a quartz blade (7) whose face supporting the microstrip line (11) is brought into contact with the dielectric rod (6) by its non-bevelled end, the microstrip line (11) being partially covered by the dielectric rod (6) in order to receive the energy at the interface between the two dielectric materials (6, 7).

3. A coupling device according to claim 1, characterized in that the second dielectric material ($\varepsilon_2$) is air, the dielectric rod (6) comprising beyond the bevel an extension which supports the microstrip line (11) and the semiconductor component (10), the coupling device being monolithic and completely supported by the dielectric rod (6).

4. A coupling device according to claim 1, characterized in that the dielectric waveguide is constituted by a rod (6) made of alumina.

5. A coupling device according to claim 1, characterized in that the dielectric waveguide is constituted by a rod (6) made of a semi-insulating material of the group III-V, such as GaAs.

6. A coupling device according to claim 1, characterized in that the semiconductor component (10) is a naked diode pastille of the Schottky type, mounted on the microstrip line (11) by means of its outside connection beams.

7. A mixer stage between a microwave input signal and a local oscillator signal, both injected into the metal waveguide (8), characterized in that it comprises a coupling device according to claim 1, and further a matching microstrip line (12) between a mixer diode (10) and an intermediate frequency filter constituted by a plurality of large metal coatings (14, 16, 18) constituting capacitors and a plurality of small metal coatings (15, 17) constituting inductors, the metal coatings (11, 12, 14 to 18) and the diode (10) being supported on a common substrate whose rear surface is metal-coated in order to constitute the capacitors and the earth plane, the intermediate frequency output of the mixer stage being available at a coaxial connector (20) which is soldered to a matching microstrip line (19), the mixer diode (10) being further DC-biassed via the connector (20).

8. A mixer stage according to claim 7, characterized in that the substrate supporting the metal coatings (11, 12, 14 to 19) and the diode (10) is a quartz blade (7) which is in contact with the dielectric waveguide (6).

9. A mixer stage according to claim 7, characterized in that the substrate supporting the metal coatings (11, 12, 14 to 19) and the diode (10) is the dielectric rod which constitutes the dielectric waveguide (6), this mixer stage being an integrated and monolithic component, the dielectric rod being made from a half-insulating material of the group III-V such as GaAs and the diode being made in the same material.

# FIG_1

# FIG_2

# FIG_3

9

# FIG_4

# FIG_5

# FIG_6